# EUROPEAN PATENT APPLICATION

(11) **EP 4 848 957 A1**
(43) Date of publication of application: **02.12.2026**
(21) Application number: 26177735.3
(22) Date of filing: 08.05.2026
(51) Int. Cl.: H10K 59/121, H10K 59/131

(54) **ELECTROLUMINESCENT DISPLAY DEVICE**

(30) Priority: 30.05.2025 KR 20250070885
(71) Applicant: LG Display Co., Ltd., Seoul 07336 (KR)
(72) Inventor: LEE, Seon-Woo, 10845 Paju-si, Gyeonggi-do (KR); KIM, Seong-Jun, 10845 Paju-si, Gyeonggi-do (KR)
(74) Representative: Bryn-Jacobsen, Caelia

(57) **Abstract**

An electroluminescent display device including a substrate (110), a thin film transistor (Tr), a storage capacitor (Cst), a light-emitting diode (De), a first gate line (GL1) electrically connected to the thin film transistor (Tr), and a second gate line (GL2) spaced apart from the first gate line (GL1) with the thin film transistor (Tr) interposed between the first and second gate lines. Also, an auxiliary power line (AP) is disposed between the first and second gate lines (GL1, GL2), and a cushion pattern (142b) is electrically connected to the storage capacitor (Cst). The cushion pattern (142b) and the auxiliary power line (AP) form a compensation capacitor (Cm) configured to compensate for variation in parasitic capacitance between the second gate line (GL2) and the cushion pattern (142b) caused by overlay misalignment between a first conductive layer including the cushion pattern (142b) and a second conductive layer including the auxiliary power line (AP).

## Description

### CROSS-REFERENCE TO RELATED APPLICATION

The present application claims priority to Korean Patent Application No. 10-2025-0070885 filed in the Republic of Korea on May 30, 2025.

### BACKGROUND

### Technical Field

The present disclosure relates to a display device, and more particularly, to an electroluminescent display device including a light-emitting diode.

### Discussion of the Related Art

As one of the flat panel display devices, an electroluminescent display device has wide viewing angles, as compared with a liquid crystal display device, because it is self-luminous. The electroluminescent display device also has advantages of a thin thickness, light weight and low power consumption because a backlight unit is not necessary. In addition, the electroluminescent display device is driven by low voltages of direct current (DC) and has a fast response time. Further, the electroluminescent display device is strong against the external impacts and is used in a wide range of temperatures because its components are solids. Also, the electroluminescent display device can be manufactured at low costs.

Also, the electroluminescent display device implements an image through light emitted by a light-emitting diode, and the light-emitting diode emits light due to the radiative recombination of an exciton. In addition, the exciton is formed from an electron and a hole by injecting charges into a light-emitting layer between a cathode for injecting electrons and an anode for injecting holes in a light-emitting diode. Further, the electroluminescent display device can include a plurality of sub-pixels, and each sub-pixel can be driven by being connected to a plurality of signal lines, and can be affected by the operation of other signal lines for driving adjacent sub-pixels, thereby decreasing the luminance.

### SUMMARY OF THE DISCLOSURE

Accordingly, examples of the present disclosure are directed to an electroluminescent display device substantially obviating one or more of the problems due to limitations and disadvantages of the related art. An aspect of the present disclosure is to provide an electroluminescent display device capable of minimizing the influence of adjacent signal lines and preventing luminance degradation. Additional features and aspects will be set forth in the following description, and in part will be apparent from the description, or can be learned by practice of the inventive concepts provided herein. Other features and aspects of the inventive concepts can be realized and attained by the structure particularly pointed out in the written description, or derivable therefrom, and the claims hereof as well as the appended drawings.

To achieve these and other aspects of the inventive concepts, as embodied and broadly described herein, an electroluminescent display device includes a substrate, a thin film transistor over the substrate, a storage capacitor electrically connected to the thin film transistor, a light-emitting diode electrically connected to the thin film transistor and the storage capacitor, a first gate line electrically connected to the thin film transistor and extending in a first direction, a second gate line spaced apart from the first gate line in a second direction crossing the first direction. Also, the thin film transistor is interposed between the first and second gate lines, an auxiliary power line is disposed between the first and second gate lines and electrically connected to the thin film transistor, and a cushion pattern is disposed between the second gate line and the storage capacitor. In addition, a compensation capacitor includes the cushion pattern and the auxiliary power line. It is to be understood both the foregoing general description and the following detailed description are by example and explanatory and are intended to provide further explanation of the present disclosure as claimed.

### BRIEF DESCRIPTION OF THE DRAWINGS

The accompanying drawings, which are included to provide a further understanding of the present disclosure and which are incorporated in and constitute a part of this application, illustrate an example of the present disclosure and together with the description serve to explain principles of the present disclosure. In the drawings:
FIG. 1 is a schematic plan view of an electroluminescent display device according to an example of the present disclosure;
FIG. 2 is a schematic plan view of an electroluminescent display device according to the example of the present disclosure;
FIG. 3 is a schematic plan view of an electroluminescent display device according to the example of the present disclosure;
FIG. 4 is a schematic plan view of an electroluminescent display device according to another example of the present disclosure;
FIG. 5 is a cross-sectional view corresponding to the line I-I' of FIG. 4;
FIG. 6 is a cross-sectional view corresponding to the line II-II' of FIG. 4;
FIG. 7 is a schematic plan view of an electroluminescent display device according to another example of the present disclosure in which the overlay variation occurs;
FIG. 8 is a cross-sectional view corresponding to the line III-III' of FIG. 7; and
FIG. 9 is a cross-sectional view corresponding to the line IV-IV' of FIG. 7.

### DETAILED DESCRIPTION OF THE EXAMPLES

The terms used in the examples of the present disclosure have been selected from widely used, current terms, taking functionality into consideration. However, these terms can vary depending on the intentions of those skilled in the art, precedents, the emergence of new technologies, etc. In certain situations, the applicant can arbitrarily select terms, in which their meanings will be described in detail in the relevant description. Therefore, the terms used in the present disclosure should be defined not simply based on their names, but based on their meaning and the overall context of the present disclosure.

When a part throughout the present disclosure is said to "include" a component, unless otherwise specifically stated, this does not exclude other components but rather implies the inclusion of other components. Also, the expression "at least one of a, b, and c" described throughout the present disclosure can encompass "a alone," "b alone," "c alone," "a and b," "a and c," "b and c," or "all a, b, and c." Further, the advantages and features of the present disclosure, and methods for achieving them, will become apparent with reference to the examples described in detail below, along with the accompanying drawings. Still further, the shapes, areas, ratios, angles, numbers, etc. disclosed in the drawings used to explain the examples herein are illustrative and are not limited to the examples illustrated. When describing the examples, detailed descriptions of related known technologies are omitted if they are deemed to unnecessarily obscure the gist of the examples.

Continuing, when used herein, terms such as "include," "have," and "consist of" can be used to indicate additional components can be added. Also, when a component is expressed in the singular, the plural is also included unless otherwise explicitly stated. Further, when interpreting a component, even if not explicitly stated, the error range is assumed to be included. Still further, when describing a positional relationship, for example, when describing the positional relationship between two parts using terms such as "on," "above," "below," or "next to," one or more other components can be located between the two parts. Also, when an element or layer is referred to as "on" another element or layer, this includes both situations where the other element is directly on top of the other element or where another layer or element is interposed.

In addition, although terms such as "first" and "second" are used to describe various components, these components are not limited by these terms as such terms are used solely to distinguish one component from another. Therefore, a "first" component referred to below can also be a "second" component within the technical scope of the present disclosure. Further, the area, length, or thickness of each component described in the present disclosure is illustrated for convenience of explanation, and the present disclosure is not necessarily limited to the area and thickness of the illustrated components.

Also, the features of each of the various examples of the present disclosure can be partially or fully combined or combined with each other, enabling various technical interlocking and operation. In addition, each example can be implemented independently of the other or can be implemented together in a related manner. Further, the terms described below are defined based on their functions in the implementation of the present disclosure and can vary depending on the intent or custom of the user or operator. Therefore, their definitions should be based on the overall content of the present disclosure. Unless otherwise specified, the transistors constituting the pixel circuit of the present disclosure can include one or more of an oxide thin film transistor (Oxide TFT), an amorphous silicon TFT (a-Si TFT), or a low-temperature polysilicon TFT (LTPS TFT).

Continuing, the following examples are described with a focus on an organic light-emitting diode (OLED) display device. However, examples of the present disclosure are not limited to organic light-emitting diode (OLED) display devices and can also be applied to inorganic light-emitting diode display devices containing inorganic light-emitting materials and micro LED display devices. For example, examples of the present disclosure can also be applied to quantum dot (QD) display devices. In other words, the display device of the present disclosure can be a light-emitting display device including a light-emitting diode, a quantum dot light-emitting display device including a quantum dot light-emitting diode, or a micro LED display device including a micro-LED.

Also, terms such as "first," "second," and "third" are used to distinguish configurations by example, and the examples are not limited to these terms. Therefore, the same term can refer to different configurations depending on the example. Any implementation described herein as an "example" is not necessarily to be construed as preferred or advantageous over other implementations. Also, in describing a temporal relationship, when the temporal order is described as, for example, "after," "subsequent," "next," and "before," a situation not continuous can be included unless a more limiting term, such as "just," "immediate(ly)," or "direct(ly)" is used.

Further, the expression of a first element, a second elements "and/or" a third element should be understood as one of the first, second and third elements or as any or all combinations of the first, second and third elements. By way of example, A, B and/or C can refer to only A; only B; only C; any or some combination of A, B, and C; or all of A, B, and C. Reference will now be made in detail to exemplary examples of the disclosure, examples of which are illustrated in the accompanying drawings.

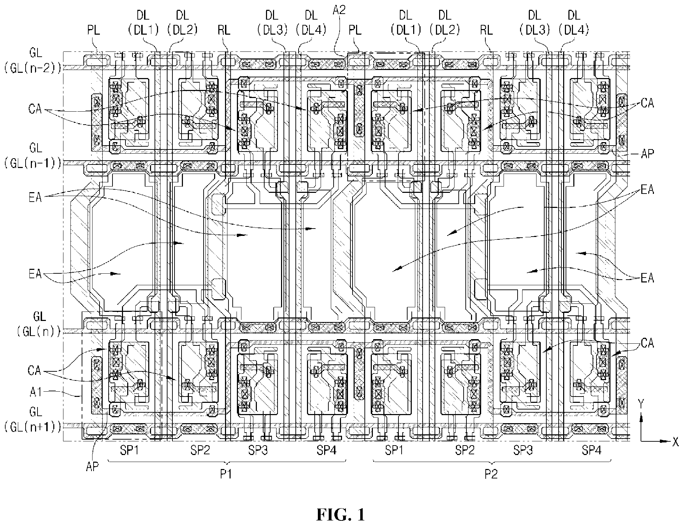

FIG. 1 is a schematic plan view of an electroluminescent display device according to an example of the present disclosure. In FIG. 1, the electroluminescent display device according to the example of the present disclosure can include a plurality of pixels P1 and P2 arranged in a first direction X and a second direction Y crossing each other, and each of the plurality of pixels P1 and P2 can include a plurality of sub-pixels SP1, SP2, SP3, and SP4.

For example, the plurality of pixels P1 and P2 can include first and second pixels P1 and P2 arranged to be adjacent to each other in the first direction X, and each of the first and second pixels P1 and P2 can include first, second, third, and fourth sub-pixels SP1, SP2, SP3, and SP4. The first, second, third, and fourth sub-pixels SP1, SP2, SP3, and SP4 can be red, green, white, and blue sub-pixels, respectively. The first, second, third, and fourth sub-pixels SP1, SP2, SP3, and SP4 can be sequentially arranged substantially in the first direction X. However, examples of the present disclosure are not limited thereto. In other examples, the number and arrangement of the first, second, third, and fourth sub-pixels SP1, SP2, SP3, and SP4 can vary. Each of the first, second, third, and fourth sub-pixels SP1, SP2, SP3, and SP4 can include an emission part EA and a circuit part CA. The emission part EA and the circuit part CA of each sub-pixel SP1, SP2, SP3, and SP4 can be disposed in the second direction Y. A light-emitting diode can be provided in the emission part EA, and at least one transistor and at least one capacitor can be provided in the circuit part CA.

The emission parts EA of the first, second, third, and fourth sub-pixels SP1, SP2, SP3, and SP4 can be sequentially disposed in the first direction X to be adjacent to each other. Here, at least one of the emission parts EA of the first, second, third, and fourth sub-pixels SP1, SP2, SP3, and SP4 can have a different size from others. For example, the areas of the emission parts EA of the first and third sub-pixels SP1 and SP3 can be greater than the areas of the emission parts EA of the second and fourth sub-pixels SP2 and SP4. At this time, the emission parts EA of the first and third sub-pixels SP1 and SP3 can have substantially the same area, and the emission parts EA of the second and fourth sub-pixels SP2 and SP4 can have substantially the same area. However, examples of the present disclosure are not limited thereto. In other examples, the emission parts EA of the first, second, third, and fourth sub-pixels SP1, SP2, SP3, and SP4 can have different areas or can have the same area.

In addition, in other examples, the circuit parts CA of the first, second, third, and fourth sub-pixels SP1, SP2, SP3, and SP4 can be substantially sequentially arranged in the first direction X, but the circuit parts CA of the first and second sub-pixels SP1 and SP2 can be spaced apart from the circuit parts CA of the third and fourth sub-pixels SP3 and SP4 in the second direction Y. In such circumstances, the circuit parts CA of the first and second sub-pixels SP1 and SP2 can be adjacent to each other in the first direction X, and the circuit parts CA of the third and fourth sub-pixels SP3 and SP4 can be adjacent to each other in the first direction X. Accordingly, the circuit parts CA of the first and second sub-pixels SP1 and SP2 can be disposed on one of upper and lower sides of the corresponding emission parts EA, and the circuit parts CA of the third and fourth sub-pixels SP3 and SP4 can be disposed on the other of the upper and lower sides of the corresponding emission parts EA. For example, the circuit parts CA of the first and second sub-pixels SP1 and SP2 of the first pixel P1 can be disposed on the lower sides of the corresponding emission parts EA, and the circuit parts CA of the third and fourth sub-pixels SP3 and SP4 of the first pixel P1 can be disposed on the upper sides of the corresponding emission parts EA in the context of the figure. In addition, the circuit parts CA of the first and second sub-pixels SP1 and SP2 of the second pixel P2 can be disposed on the upper sides of the corresponding emission parts EA, and the circuit parts CA of the third and fourth sub-pixels SP3 and SP4 of the second pixel P2 can be disposed on the lower sides of the corresponding emission parts EA in the context of the figure.

Further, the emission parts EA and the circuit parts CA of the first, second, third, and fourth sub-pixels SP1, SP2, SP3, and SP4 can be defined by a plurality of lines crossing each other. Specifically, a plurality of gate lines GL can be provided to extend in the first direction X, which is a horizontal direction in the context of the figure, and to be spaced apart in the second direction Y, which is a vertical direction in the context of the figure. Also, a plurality of data lines DL, a plurality of power lines PL, and a plurality of reference lines RL can be provided to extend in the second direction Y and to be spaced apart in the first direction X. For example, the plurality of data lines DL can include first, second, third, and fourth data lines DL1, DL2, DL3, and DL4 corresponding to each of the first and second pixels P1 and P2 and being sequentially disposed in the first direction X. One power line PL and one reference line RL can correspond to each of the first and second pixels P1 and P2 and can alternate each other in the first direction X.

Further, the first and second data lines DL1 and DL2 or the third and fourth data lines DL3 and DL4 can be disposed between the power line PL and the reference line RL adjacent to each other. Also, one of the first, second, third, and fourth sub-pixels SP1, SP2, SP3, and SP4 can be provided between the data line DL and the power line PL adjacent to each other and between the data line DL and the reference line RL adjacent to each other. In various examples, no sub-pixel can be provided between the first and second data lines DL1 and DL2 and between the third and fourth data lines DL3 and DL4. Accordingly, a distance between the first and second data lines DL1 and DL2 and a distance between the third and fourth data lines DL3 and DL4 can be smaller than a distance between the second and third data lines DL2 and DL3 and a distance between the fourth and first data lines DL4 and DL1 of different pixels P1 and P2.

Continuing, in the electroluminescent display device according to the example of the present disclosure, two adjacent data lines DL, for example, the first and second data lines DL1 and DL2 or the third and fourth data lines DL3 and DL4 can be connected to one output terminal of a data driving unit, i.e., a channel of the data driving unit, so data voltages sequentially output from the channel can be transmitted to two adjacent sub-pixels, for example, the first and second sub-pixels SP1 and SP2 or the third and fourth sub-pixels SP3 and SP4 in order. Accordingly, the number of the output terminals of the data driving unit, i.e., the number of pins can be decreased even if the number of pixels increases, and the size and number of the data driving units can be minimized or decreased, thereby reducing the manufacturing costs.

Next, the emission part EA or the circuit part CA can be provided between adjacent gate lines GL. For example, the plurality of gate lines GL can include an (n-2)th gate line GL(n-2), an (n-1)th gate line GL(n-1), an nth gate line GL(n), and an (n+1)th gate line GL(n+1). Here, n is an integer.

Further, a distance between the (n-1)th gate line GL(n-1) and the nth gate line GL(n) can be greater than a distance between the (n-2)th gate line GL(n-2) and the (n-1)th gate line GL(n-1) and a distance between the nth gate line GL(n) and the (n+1)th gate line GL(n+1). Still further, the emission part EA can be disposed between the (n-1)th gate line GL(n-1) and the nth gate line GL(n). Also, the circuit part CA can be disposed between the (n-2)th gate line GL(n-2) and the (n-1)th gate line GL(n-1) and between the nth gate line GL(n) and the (n+1)th gate line GL(n+1). Here, the circuit parts CA of the first and second sub-pixels SP1 and SP2 of the first pixel P1 and the third and fourth sub-pixels SP3 and SP4 of the second pixel P2 can be connected to the nth gate line GL(n). Also, the circuit parts CA of the third and fourth sub-pixels SP3 and SP4 of the first pixel P1 and the first and second sub-pixels SP1 and SP2 of the second pixel P2 can be connected to the (n-1)th gate line GL(n-1).

In various examples, in each of the first and second pixels P1 and P2, the circuit parts CA of the first and second sub-pixels SP1 and SP2 can be substantially horizontally symmetrical to each other in the first direction X, and the circuit parts CA of the third and fourth sub-pixels SP3 and SP4 can be substantially horizontally symmetrical to each other in the first direction X. Additionally, in each of the first and second pixels P1 and P2, the circuit parts CA of the first and third sub-pixels SP1 and SP3 can be substantially vertically symmetrical in the second direction Y, and the circuit parts CA of the second and fourth sub-pixels SP2 and SP4 can be substantially vertically symmetrical in the second direction Y.

Further, the circuit parts CA of the first, second, third, and fourth sub-pixels SP1, SP2, SP3, and SP4 of the first pixel P1 can be substantially vertically symmetrical in the second direction Y to the circuit parts CA of the first, second, third, and fourth sub-pixels SP1, SP2, SP3, and SP4 of the second pixel P2, respectively. That is, the same color sub-pixels SP of the adjacent pixels P1 and P2 can have a flip structure in which the circuit parts CA are substantially inverted vertically in the second direction Y. As such, in the electroluminescent display device according to the example of the present disclosure, two adjacent sub-pixels SP can be driven by being connected to one output terminal of the data driving unit, thereby minimizing or decreasing the size and number of the data driving units. In other examples, however, the circuit parts CA of the first, second, third, and fourth sub-pixels SP1, SP2, SP3, and SP4 of the first pixel P1 can be substantially horizontally symmetrical in the first direction X to the circuit parts CA of the first, second, third, and fourth sub-pixels SP1, SP2, SP3, and SP4 of the second pixel P2, respectively. Still further, in yet other examples, pixels are not flipped as, so long as there is an adjacent gate line that can be coupled to a storage capacitor.

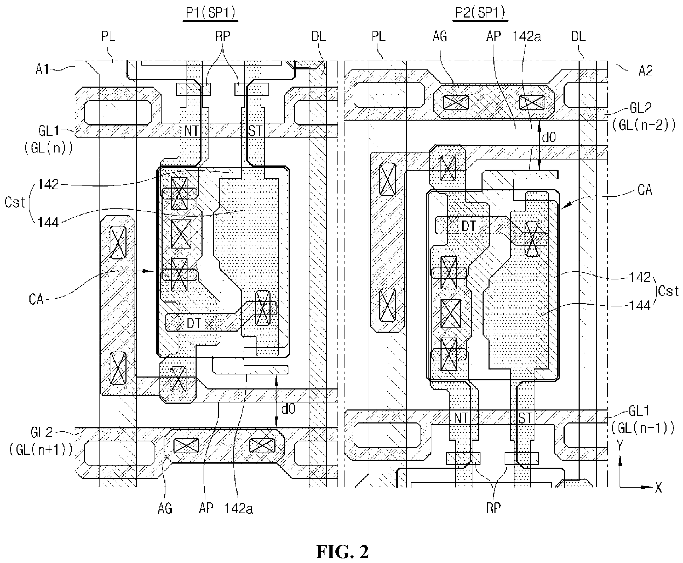

Next, the configuration of the sub-pixel of the electroluminescent display device according to the example of the present disclosure will be described in detail with reference to FIG. 2. FIG. 2 is a schematic plan view of an electroluminescent display device according to the example of the present disclosure and is a view enlarging the area A1 and the area A2 of FIG. 1. FIG. 2 shows the circuit parts CA of the first sub-pixels SP1 of two adjacent pixels P1 and P2 and will be described with reference to FIG. 1 together. In FIG. 2, the first sub-pixels SP1 of the first and second pixels P1 and P2 can have substantially the same configuration and can be vertically symmetrical in the second direction Y.

As shown in FIG. 2, the circuit part CA of the first sub-pixel SP1 can be defined by first and second gate lines GL1 and GL2 of the first direction X and the data line DL and the power line PL of the second direction Y. Also, a switching transistor ST, a driving transistor DT, a sensing transistor NT, and a storage capacitor Cst can be provided in the circuit part CA. Specifically, the first gate line GL1, which is an own gate line or a current gate line transmitting a scan signal to the first sub-pixel SP1, and the second gate line GL2, which is adjacent thereto and is a previous gate line or a next gate line not transmitting a scan signal to the first sub-pixel SP1, can extend in the first direction X. In contrast, the data line DL and the power line PL can extend in the second direction Y.

Also shown in FIG. 2, the first and second gate lines GL1 and GL2 can cross the data line DL and the power line PL. Further, each of the first and second gate lines GL1 and GL2 can have a width in a crossing area with the data line DL and the power line PL greater than a width in other areas and can have a hole in the crossing area, thereby having a substantially ring shape. In operation, the first and second gate lines GL1 and GL2 can transmit a scan signal such as a gate voltage Vg. In addition, an auxiliary gate line AG can be provided to overlap the second gate line GL2. Also, the auxiliary gate line AG can be disposed between the data line DL and the power line PL and can be connected to the second gate line GL2 through contact holes. In various examples, the auxiliary gate line AG can improve the transmission of the scan signal by configuring a dual gate line.

Also, in the first pixel P1, the first gate line GL1 can be the nth gate line (GL(n)) of FIG. 1, and the second gate line GL2 can be the (n+1)th gate line GL(n+1) of FIG. 1. Similarly, in the second pixel P2, the first gate line GL1 can be the (n-1)th gate line (GL(n-1)) of FIG. 1, and the second gate line GL2 can be the (n-2)th gate line GL(n-2) of FIG. 1.

Next, the data line DL and the power line PL can extend in the second direction Y and can be spaced apart from each other in the first direction X. Here, a width of the power line PL can be greater than a width of the data line DL. In operation, the power line PL, can be referred to as a main power line or a vertical power line, can transmit a high potential voltage EVDD, and the data line DL can transmit a data voltage Vdata. In addition, an auxiliary power line AP can be further provided to be connected to the power line PL enabling the auxiliary power line AP, which can be referred to as a horizontal power line, to transmit the high potential voltage EVDD. Also, the auxiliary power line AP can extend substantially in the first direction X and be disposed between the first gate line GL1 and the second gate line GL2. Further, the auxiliary power line AP can overlap and/or cross the data line DL and the power line PL. Also, the auxiliary power line AP can include a portion extending in the second direction Y overlapping the power line PL while contacting the power line PL through contact holes. Accordingly, the high potential voltage EVDD transmitted in the second direction Y through the power line PL can also be transmitted in the first direction X through the auxiliary power line AP.

Still further, the auxiliary power line AP can be disposed to be adjacent to the second gate line GL2. In other words, a distance between the auxiliary power line AP and the first gate line GL1 can be greater than a distance between the auxiliary power line AP and the second gate line GL2. In this situation, the auxiliary power line AP can be disposed between the second gate line GL2 and the storage capacitor Cst.

Next, the switching transistor ST can be provided to be connected to the first gate line GL1 and the data line DL, the driving transistor DT can be provided to be connected to the switching transistor ST and the auxiliary power line AP, and the sensing transistor NT can be provided to be connected to the driving transistor DT. Here, the sensing transistor NT can also be connected to the reference line RL of FIG. 1.

In addition, the storage capacitor Cst can be provided to be connected to the switching transistor ST, the driving transistor DT, and the sensing transistor NT. Also, the storage capacitor Cst can include a first capacitor electrode 142 and a second capacitor electrode 144. Further, the first capacitor electrode 142 can be connected to the driving transistor DT and the sensing transistor NT, and the second capacitor electrode 144 can be connected to the switching transistor ST and the driving transistor DT. Still further, the first capacitor electrode 142 can extend to overlap the driving transistor DT and the sensing transistor NT, and the second capacitor electrode 144 can be spaced apart from the sensing transistor NT.

Meanwhile, a cushion pattern 142a can be further provided between the second gate line GL2 and the storage capacitor Cst. More particularly, the cushion pattern 142a can be disposed between the auxiliary power line AP and the first and second capacitor electrodes 142 and 144 of the storage capacitor Cst in the second direction Y. Here, the cushion pattern 142a can be connected to the first capacitor electrode 142 of the storage capacitor Cst. In addition, the cushion pattern 142a can extend from the first capacitor electrode 142 substantially in the first direction X while also spaced apart from the auxiliary power line AP and the second capacitor electrode 144.

In the electroluminescent display device according to the example of the present disclosure, after the first sub-pixel SP1 of the second pixel P2 connected to the (n-1)th gate line GL(n-1) is driven, the first sub-pixel SP1 of the first pixel P1 connected to the nth gate line GL(n) can be driven, and then a first sub-pixel SP1 of a next second pixel P2 connected to the (n+1)th gate line GL(n+1) can be driven.

At this time, in the first sub-pixel SP1 of the first pixel P1, a node connected to the second capacitor electrode 144 of the storage capacitor Cst can be affected by the operation of the second gate line GL2 which is the (n+1)th gate line GL(n+1) adjacent thereto. In other words, in the first sub-pixel SP1 of the first pixel P1, a kickback voltage can increase due to the scan signal of the second gate line GL2, resulting in a decrease in luminance. Accordingly, in the electroluminescent display device according to the example of the present disclosure, by providing the cushion pattern 142a between the second capacitor electrode 144 of the storage capacitor Cst and the second gate line GL2 adjacent thereto and generating parasitic capacitance between the second gate line GL2 and the cushion pattern 142a, the influence of the scan signal of the second gate line GL2 can be minimized to prevent the decrease in luminance.

In addition, a repair pattern RP can be further provided to correspond to each of the switching transistor ST and the sensing transistor NT. In various examples, the repair pattern RP can be formed of the same material and on the same layer as the data line DL and the power line PL and can overlap each of the switching transistor ST and the sensing transistor NT. Accordingly, when an electrical short circuit occurs between the lines GL1, GL2, DL, and PL, the transistors ST, DT, and NT, and/or the storage capacitor Cst, the repair pattern RP can be intended to facilitate their separation and can form a step height under the switching transistor ST and the sensing transistor NT. As such, in the electroluminescent display device according to the example of the present disclosure, the first sub-pixels SP1 of the first and second pixels P1 and P2 emitting the same color can have substantially the same configuration and can be vertically symmetrical in the second direction Y.

Also, the circuit part CA of the first sub-pixel SP1 can be configured by overlaying patterns which are formed through different processes. For example, a first metal layer, a second metal layer, and a semiconductor layer formed through different processes can be overlaid to form the plurality of transistors ST, DT, and NT and the storage capacitor Cst. Here, the first metal layer can include the power line PL, the data line DL, the auxiliary gate line AG, the first capacitor electrode 142, and the cushion pattern 142a. In addition, the second metal layer can include the first and second gate lines GL1 and GL2, the auxiliary power line AP, and a gate, source, or drain electrode. Meanwhile, the semiconductor layer can include the second capacitor electrode 144 and an active layer.

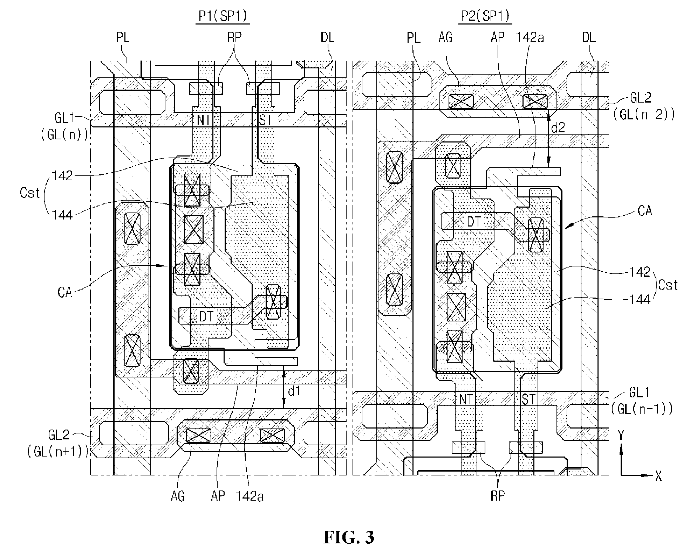

However, when an overlay variation occurs between the first metal layer and the second metal layer, the parasitic capacitance can vary. In this situation, since the first sub-pixels SP1 of the first and second pixels P1 and P2 can be vertically symmetrical, the parasitic capacitance variation in the first pixel P1 and the parasitic capacitance variation in the second pixel P2 can be different from each other, resulting in a luminance deviation depending on the location. As a result, luminance deviation can increase as the overlay variation increases, which will be described with reference to FIG. 3.

FIG. 3 is a schematic plan view of an electroluminescent display device according to the example of the present disclosure and shows a situation where an overlay variation occurs between the first metal layer and the second metal layer. In FIG. 3, the first and second gate lines GL1 and GL2 and the auxiliary power line AP, which are the second metal layer, can be shifted in the relatively positive second direction Y with respect to the auxiliary gate line AG, the first capacitor electrode 142, and the cushion pattern 142a, which are the first metal layer. At this time, since the first sub-pixels SP1 of the first and second pixels P1 and P2 are provided to be vertically inverted, in the first sub-pixel SP1 of the first pixel P1, a first distance d1 between the cushion pattern 142a and the second gate line GL2 can be smaller than a reference distance d0 between the cushion pattern 142a and the second gate line GL2 of FIG. 2, and in the first sub-pixel SP1 of the second pixel P2, a second distance d2 between the cushion pattern 142a and the second gate line GL2 can be greater than the reference distance d0 between the cushion pattern 142a and the second gate line GL2 of FIG. 2. Accordingly, the parasitic capacitance generated between the second gate line GL2 and the cushion pattern 142a in the first sub-pixel SP1 of the first pixel P1 can be different from the parasitic capacitance generated between the second gate line GL2 and the cushion pattern 142a in the first sub-pixel SP1 of the second pixel P2. For example, the parasitic capacitance generated in the first sub-pixel SP1 of the first pixel P1 can be greater than the parasitic capacitance generated in the first sub-pixel SP1 of the second pixel P2.

Due to the difference in parasitic capacitance caused by the overlay variation, the characteristics of the first sub-pixels SP1 of the first and second pixels P1 and P2 can be different from each other, resulting in the luminance deviation depending on the location. To minimize the luminance deviation, a distance between the second gate line GL2 and the storage capacitor Cst can be increased. However, in this situation, the area of the circuit part CA can increase, so the area of the emission part EA can decrease. Accordingly, since the aperture ratio decreases, the light-emitting diode provided in the emission part EA can be easily deteriorated, resulting in an afterimage and a decrease in lifetime.

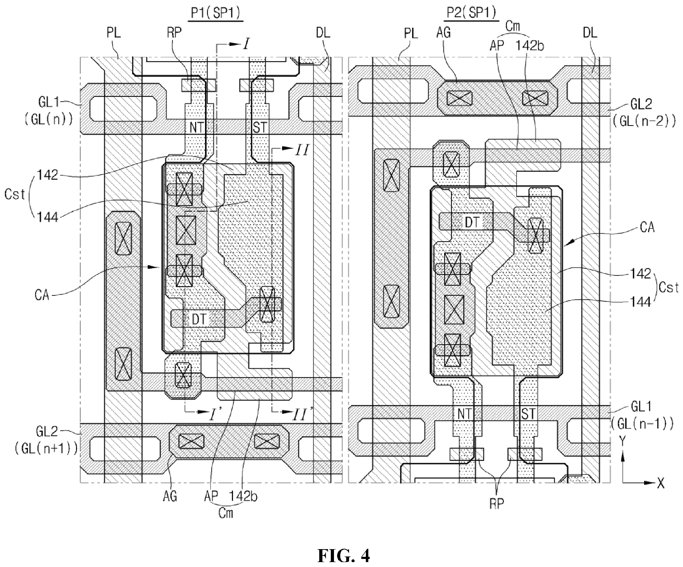

Continuing, an electroluminescent display device according to another example of the present disclosure capable of preventing the luminance variation caused by the difference in parasitic capacitance without reducing the aperture ratio will be described with reference to FIG. 4. FIG. 4 is a schematic plan view of an electroluminescent display device according to another example of the present disclosure and shows the circuit parts CA of the first sub-pixels SP1 of two adjacent pixels P1 and P2. The electroluminescent display device according to another example of the present disclosure has substantially the same configuration as the previous example, except for the cushion pattern. The same parts as those of the previous example are designated by the same or similar reference signs, and explanation for the same parts can be shortened or omitted.

As shown in FIG. 4, in the electroluminescent display device according to another example of the present disclosure, the cushion pattern 142b can be provided between the second gate line GL2 and the storage capacitor Cst in the second direction Y. The cushion pattern 142b can be connected to the first capacitor electrode 142 of the storage capacitor Cst and can be spaced apart from the second capacitor electrode 144 and the second gate line GL2. The cushion pattern 142b can overlap the auxiliary power line AP. The cushion pattern 142b and the auxiliary power line AP overlapping each other can form a compensation capacitor Cm.

Here, a width of the cushion pattern 142b can be greater than a width of the auxiliary power line AP. At this time, both sides of the auxiliary power line AP can be disposed on the cushion pattern 142b. However, examples of the present disclosure are not limited thereto. In other examples, the width of the cushion pattern 142b can be the same as the width of the auxiliary power line AP. For example, the difference between the width of the cushion pattern 142b and the width of the auxiliary power line AP can be 0 µm to 10 µm, preferably 2 µm to 8 µm, more preferably 3 µm to 7 µm, but is not limited thereto. As such, in the electroluminescent display device according to another example of the present disclosure, the compensation capacitor Cm can be formed by overlapping the cushion pattern 142b connected to the first capacitor electrode 142 of the storage capacitor Cst with the auxiliary power line AP.

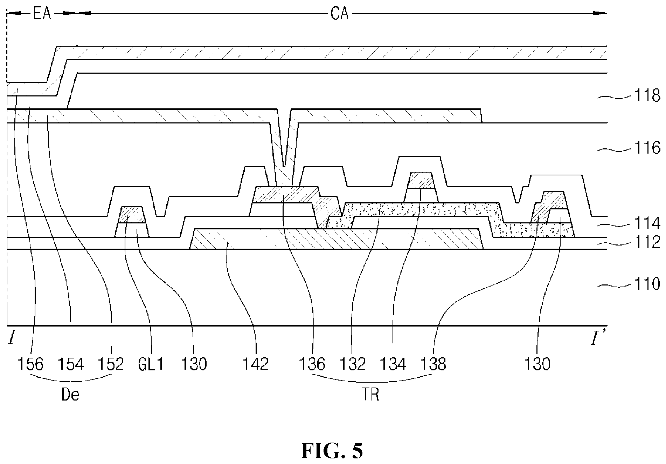

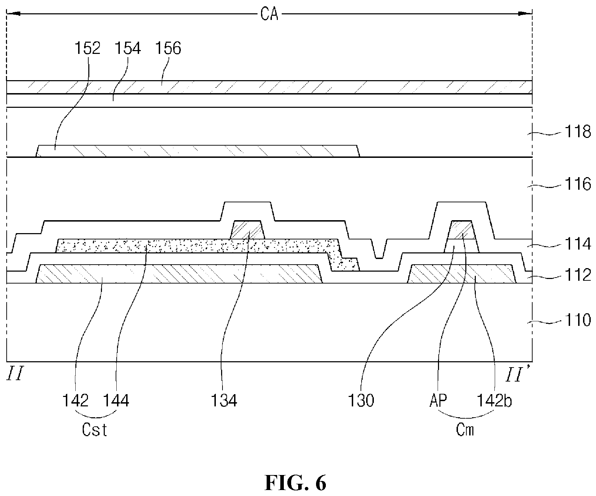

Next, a cross-sectional structure of the electroluminescent display device according to another example of the present disclosure will be described in detail with reference to FIG. 5 and FIG. 6. FIG. 5 and FIG. 6 are cross-sectional views of an electroluminescent display device according to another example of the present disclosure. FIG. 5 shows a cross-section corresponding to the line I-I' of FIG. 4, FIG. 6 shows a cross-section corresponding to the line II-II' of FIG. 4, and will be described with reference to FIG. 4 together.

In FIG. 5 and FIG. 6, the electroluminescent display device according to another example of the present disclosure can include a thin film transistor TR, the storage capacitor Cst, the compensation capacitor Cm, and a light-emitting diode De over a substrate 110. Specifically, the substrate 110 can be formed of a transparent insulating material, and, for example, can be a glass substrate or a plastic substrate. In various examples, polyimide can be used for the plastic substrate, and the plastic substrate can have a stacked structure including at least one polyimide layer and at least one inorganic layer. However, examples of the present disclosure are not limited thereto.

Also, the first capacitor electrode 142 and the cushion pattern 142b can be provided on the substrate 110 with the first capacitor electrode 142 and the cushion pattern 142b formed of a conductive material, such as metal or metal alloy. For example, the first capacitor electrode 142 and the cushion pattern 142b can be formed of one or more of: aluminum (Al), copper (Cu), molybdenum (Mo), titanium (Ti), chromium (Cr), nickel (Ni), tungsten (W), and an alloy thereof. In addition, the first capacitor electrode 142 and the cushion pattern 142b can have a single-layered structure or a multiple-layered structure.

As also shown in FIG. 5, the first capacitor electrode 142 can extend into an area under the thin film transistor TR and overlap the thin film transistor TR. Also, a portion of the first capacitor electrode 142 overlapping the thin film transistor TR can act as a light-shielding layer. Further, the cushion pattern 142b can be connected to the first capacitor electrode 142 and be disposed between the storage capacitor Cst and the second gate line GL2 adjacent to thereto. In addition, the data line DL and the power line PL can be provided on the substrate 110 and formed of the same material as the first capacitor electrode 142 and the cushion pattern 142b.

Meanwhile, a barrier layer can be further provided between the substrate 110 and the first capacitor electrode 142 and between the substrate 110 and the cushion pattern 142b. Also, the barrier layer can be formed as a single layer or multiple layers of an inorganic insulating material, such as silicon nitride (SiNx), silicon oxide (SiOx), or silicon oxynitride (SiON).

In addition, a buffer layer 112 can be provided on the first capacitor electrode 142 and the cushion pattern 142b as well as disposed substantially all over the substrate 110. In different examples, the buffer layer 112 can be formed as a single layer or multiple layers of an inorganic insulating material, such as silicon nitride (SiNx), silicon oxide (SiOx), or silicon oxynitride (SiON). Also, an active layer 132 and the second capacitor electrode 144 can be provided on the buffer layer 112, and can be formed of an oxide semiconductor material, such as indium gallium zinc oxide (IGZO). However, examples of the present disclosure are not limited thereto. Alternatively, the active layer 132 and the second capacitor electrode 144 can be formed of polycrystalline silicon, and in this situation, both end parts of the active layer 132 and the second capacitor electrode 144 can be doped with impurities.

As further shown in FIG. 5, the active layer 132 can include a channel region at its central portion and source and drain regions at both sides of the channel region with the active layer 132 overlapping the portion of the first capacitor electrode 142. As described above, the portion of the first capacitor electrode 142 overlapping the active layer 132 can act as a light-shielding layer, and can block light incident on the active layer 132 to prevent or reduce the active layer 132 from deteriorating due to the light. In addition, the active layer 132 can be in contact with the first capacitor electrode 142 through a contact hole provided in the buffer layer 112. Also, the second capacitor electrode 144 can overlap the first capacitor electrode 142 to form the storage capacitor Cst with the buffer layer 112 therebetween as a dielectric.

Next, a gate electrode 134, a source electrode 136, and a drain electrode 138 can be provided on the active layer 132 and the second capacitor electrode 144. In various examples, the gate electrode 134, the source electrode 136, and the drain electrode 138 can be formed of a conductive material such as metal or metal alloy, such as one or more of: aluminum (Al), copper (Cu), molybdenum (Mo), titanium (Ti), chromium (Cr), nickel (Ni), tungsten (W), and an alloy thereof. The gate electrode 134, the source electrode 136, and the drain electrode 138 can have a single-layered structure or a multiple-layered structure.

Meanwhile, a gate insulation layer 130 can be provided under the gate electrode 134, the source electrode 136, and the drain electrode 138, i.e., between the active layer 132 and the gate, source, and drain electrodes 134, 136, and 138. In various examples, the gate insulation layer 130 can be formed as a single layer or multiple layers of an inorganic insulating material, such as silicon nitride (SiNx), silicon oxide (SiOx), or silicon oxynitride (SiON).

Also, the gate insulation layer 130 can have substantially the same shape as each of the gate electrode 134, the source electrode 136, and the drain electrode 138 and can have contact holes corresponding to the gate electrode 134, the source electrode 136, and the drain electrode 138. However, examples of the present disclosure are not limited thereto. In other examples, the gate insulation layer 130 can be disposed substantially all over the substrate 110 while the gate electrode 134, the source electrode 136, and the drain electrode 138 on the gate insulation layer 130 can overlap the active layer 132. Also, the gate electrode 134 can correspond to the channel region of the active layer 132 and can be spaced apart from the source electrode 136 and the drain electrode 138 and be disposed between the source electrode 136 and the drain electrode 138. Further, the gate electrode 134 can extend to be provided over the second capacitor electrode 144 and can be in contact with the second capacitor electrode 144 through a contact hole provided in the gate insulation layer 130.

Further, the source electrode 136 and the drain electrode 138 can correspond to the source region and the drain region of the active layer 132 and can be in contact with the source region and the drain region of the active layer 132 through contact holes provided in the gate insulation layer 130, respectively. In this situation, the source electrode 136 can be in contact with top and side surfaces of the active layer 132, and the drain electrode 138 can be in contact with the top surface of the active layer 132. However, examples of the present disclosure are not limited thereto.

In addition, the source electrode 136 can be in contact with the first capacitor electrode 142 through a contact hole provided in the gate insulation layer 130 and the buffer layer 112. However, examples of the present disclosure are not limited thereto. In other examples, the source electrode 136 can be in contact with the active layer 132, and the active layer 132 can be in contact with the first capacitor electrode 142, so the source electrode 136 can be electrically connected to the first capacitor electrode 142 through the active layer 132. Also, the active layer 132, the gate electrode 134, the source electrode 136, and the drain electrode 138 can constitute the thin film transistor TR, which can be the driving transistor DT of FIG. 4.

Here, the drain electrode 138 can serve as an input electrode, and the source electrode 136 can serve as an output electrode. In this situation, the source electrode 136 can be connected to the light-emitting diode De. However, examples of the present disclosure are not limited thereto. In other examples, the input electrode can be the source electrode, and the output electrode can be the drain electrode. In this situation, the drain electrode can be connected to the light-emitting diode De. Also, one or more transistors electrically connected to the thin film transistor TR can be further provided over the substrate 110 with the one of more transistors being the switching transistor ST and/or the sensing transistor NT of FIG. 4 and having substantially the same configuration as the thin film transistor TR. However, examples of the present disclosure are not limited thereto. In other examples, the switching transistor ST and/or the sensing transistor NT can have a different configuration from the thin film transistor TR. Meanwhile, the first gate line GL1 and the auxiliary power line AP can be provided on the buffer layer 112 and can be formed of the same material as the gate electrode 134, the source electrode 136, and the drain electrode 138. The first gate line GL1 and the auxiliary power line AP can be spaced apart from the first and second capacitor electrodes 142 and 144.

Further, the gate insulation layer 130 can be provided under the first gate line GL1 and the auxiliary power line AP, and have substantially the same shape as the first gate line GL1 and the auxiliary power line AP. Also, the auxiliary power line AP can overlap the cushion pattern 142b, and the width of the auxiliary power line AP can be smaller than the width of the cushion pattern 142b. In addition, the drain electrode 138 can be connected to the auxiliary power line AP. In this situation, the drain electrode 138 can be configured as a portion of the auxiliary power line AP.

Still further, a passivation layer 114 can be provided on the gate electrode 134, the source electrode 136, the drain electrode 138, the first gate line GL1, and the auxiliary power line AP. In various examples, the passivation layer 114 can be disposed substantially all over the substrate 110, and also can be formed as a single layer or multiple layers of an inorganic insulating material, such as silicon nitride (SiNx), silicon oxide (SiOx), or silicon oxynitride (SiON).

Further, a planarization layer 116 can be provided on the passivation layer 114 and disposed substantially all over the substrate 110. As shown in FIG. 5, the planarization layer 116 can eliminate a step difference due to the layers thereunder and can have a substantially flat top surface. Also, the planarization layer 116 can be formed of an organic insulating material such as photosensitive acrylic polymer (photo acryl).

Next, a first electrode 152 can be provided on the planarization layer 116 and can be formed of a conductive material having relatively high work function. Also, the first electrode 152 can be disposed in the emission part EA and the circuit part CA. Further, in the circuit part CA, the first electrode 152 can overlap the thin film transistor TR and the storage capacitor Cst and can be in contact with the source electrode 136 through a contact hole provided in the planarization layer 116 and the passivation layer 114. Accordingly, the first electrode 152 can be electrically connected to the first capacitor electrode 142 of the storage capacitor Cst through the source electrode 136. For example, the first electrode 152 can include a transparent conductive material such as indium tin oxide (ITO) or indium zinc oxide (IZO) or can include titanium (Ti). However, examples of the present disclosure are not limited thereto.

Also, a bank 118 can be provided on the first electrode 152 with the bank 118 disposed to correspond to the circuit part CA and having an opening exposing the first electrode 152 in the emission part EA. In addition, the emission part EA can be defined by the bank 118 having the opening. In various examples, the bank 118 can cover the contract hole provided in the polarization layer 116 and the passivation layer 114. Also, the bank 118 can be formed of an organic insulating material such as photosensitive acrylic polymer (photo acryl). However, examples of the present disclosure are not limited thereto.

Meanwhile, the bank 118 can be a black bank having a light-absorbing property. In various examples, the black bank 118 can include black particles (light-absorbing particles) dispersed in an organic material (binder). For example, the organic material can be one of photosensitive acrylic polymer (photo acryl), benzocyclobutene (BCB), and polyimide, and the light-absorbing particles can be one of carbon black, carbon nanotubes (CNTs), and graphene. In addition, although not shown in the figures, a spacer can be further provided on the bank 118.

Next, a light-emitting layer 154 can be provided on the first electrode 152 exposed through the opening of the bank 118. Also, the light-emitting layer 154 can include at least one hole auxiliary layer, at least one light-emitting material layer, and at least one electron auxiliary layer. Here, the light-emitting material layer can include one of red, green, and blue luminescent materials. In addition, the luminescent material can be an organic luminescent material such as a phosphorescent compound or a fluorescent compound or can be an inorganic luminescent material such as a quantum dot.

Further, the hole auxiliary layer can include at least one of a hole injection layer (HIL) and a hole transporting layer (HTL). Also, the electron auxiliary layer can include at least one of an electron injection layer (EIL) and an electron transporting layer (ETL).

In various examples, the light-emitting layer 154 can emit white light and can be provided on top and side surfaces of the bank 118 to be disposed substantially all over the substrate 110. In such situations, the light-emitting layer 154 can include a plurality of light-emitting units emitting light of different colors and being stacked with each stack including at least one hole auxiliary layer, at least one light-emitting material layer, and at least one electron auxiliary layer. For example, the light-emitting layer 154 can have a stack structure in which two or more light-emitting units emitting different colors are stacked, and a charge generation layer (CGL) can be provided between two or more light-emitting units. However, examples of the present disclosure are not limited thereto. In other examples, at least one layer of the light-emitting layer 154, for example, the light-emitting material layer can be disposed only on the first electrode 152, and the hole auxiliary layer and the electron auxiliary layer can be disposed substantially all over the substrate 110.

Next, a second electrode 156 of a conductive material with relatively low work function can be provided on the light-emitting layer 154 with the second electrode 156 disposed substantially all over the substrate 110. Also, the second electrode 136 can be formed of a metal having relatively high reflectance. For example, the second electrode 156 can be formed of aluminum (Al), magnesium (Mg), silver (Ag), or an alloy thereof. In addition, the first electrode 152, the light-emitting layer 154, and the second electrode 156 can constitute the light-emitting diode De. Here, the first electrode 152 can serve as an anode, and the second electrode 156 can serve as a cathode. However, examples of the present disclosure are not limited thereto. In other examples, the first electrode 152 can serve as a cathode, and the second electrode 156 can serve as an anode.

In operation, light emitted from the light-emitting layer 154 of the light-emitting diode De can be output to the outside through the first electrode 152 and the first substrate 110. Also, the electroluminescent display device according to another example of the present disclosure can be a bottom emission type display device. In such examples, a color filter layer (can include red, green, and blue color filters corresponding to respective sub-pixels) can be provided between the substrate 110 and the first electrode 152.

In a number of examples, an encapsulation layer can be provided on the second electrode 156 with the encapsulation layer taking the form of a face seal formed of an organic or inorganic insulating material which is transparent and has adhesive properties or can have a multiple-layered structure in which inorganic/organic/inorganic layers are stacked.

In addition, an opposite substrate can be disposed over the encapsulation layer with the opposite substrate being a glass substrate or a metal substrate. Alternatively, the opposite substrate can be formed in the form of a film.

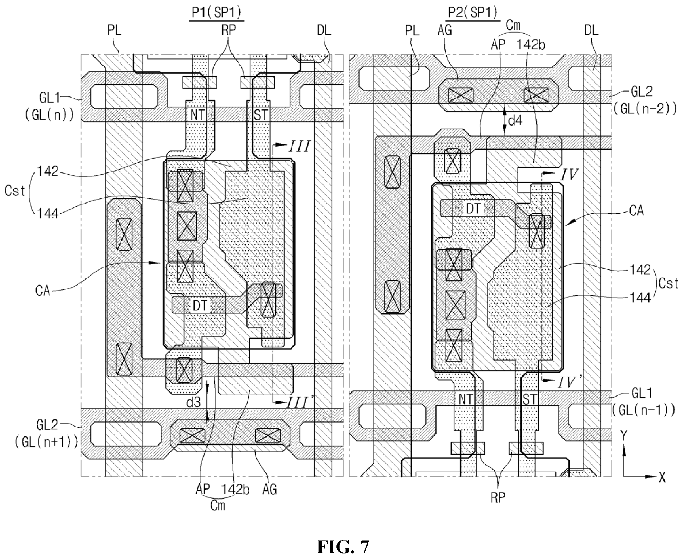

In operation, the encapsulation layer and the opposite substrate can prevent external oxygen or moisture from penetrating into the light-emitting diode De or external impacts from being applied to the light-emitting diode De. As such, in the electroluminescent display device according to another example of the present disclosure, the cushion pattern 142b and the auxiliary power line AP can be configured to overlap each other, thereby forming the compensation capacitor Cm. In various examples, the capacitance of the compensation capacitor Cm can be greater than the parasitic capacitance between the second gate line GL2 and the cushion pattern 142b. Also, the compensation capacitor Cm can have substantially the same capacitance in the first and second pixels P1 and P2 even if the overlay variation occurs. Accordingly, even if there is a difference in parasitic capacitance between the first and second pixels P1 and P2 due to the overlay variation, the influence due to the variability in parasitic capacitance can be reduced by the compensation capacitor Cm. This will be described in detail with reference to FIGS. 7 to 9.

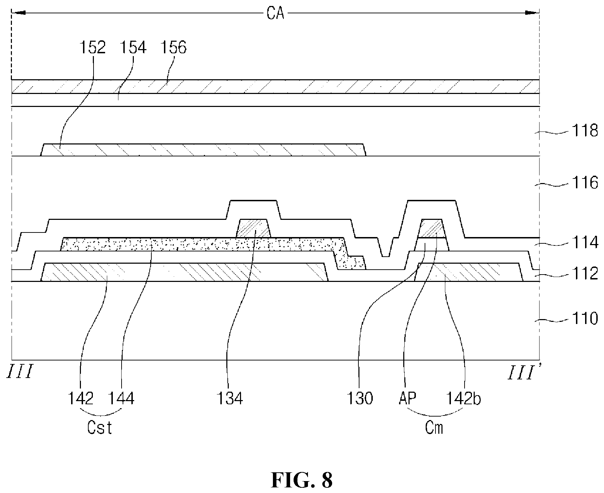

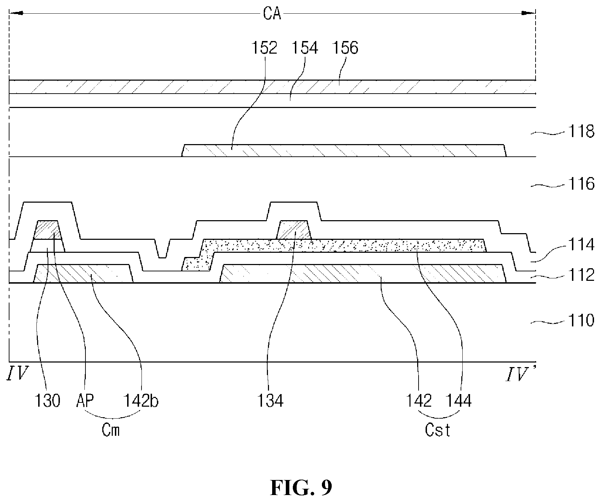

FIG. 7 is a schematic plan view of an electroluminescent display device according to another example of the present disclosure in which the overlay variation occurs, FIG. 8 is a cross-sectional view corresponding to the line III-III' of FIG. 7, and FIG. 9 is a cross-sectional view corresponding to the line IV-IV' of FIG. 7. In FIGS. 7 to 9, the first and second gate lines GL1 and GL2 and the auxiliary power line AP, which are the second metal layer, can be shifted in the relatively positive second direction Y with respect to the auxiliary gate line AG, the first capacitor electrode 142, and the cushion pattern 142a, which are the first metal layer.

At this time, since the first sub-pixels SP1 of the first and second pixels P1 and P2 are provided to be vertically inverted, a first distance d3 between the cushion pattern 142b and the second gate line GL2 in the first sub-pixel SP1 of the first pixel P1 can be smaller than a second distance d4 between the cushion pattern 142b and the second gate line GL2 in the first sub-pixel SP1 of the second pixel P2. Accordingly, the parasitic capacitance generated between the second gate line GL2 and the cushion pattern 142b in the first sub-pixel SP1 of the first pixel P1 can be different from the parasitic capacitance generated between the second gate line GL2 and the cushion pattern 142b in the first sub-pixel SP1 of the second pixel P2. For example, the parasitic capacitance generated in the first sub-pixel SP1 of the first pixel P1 can be greater than the parasitic capacitance generated in the first sub-pixel SP1 of the second pixel P2.

However, the compensation capacitor Cm generated by the cushion pattern 142b and the auxiliary power line AP overlapping each other can have substantially the same capacitance in the first and second pixels P1 and P2 even if the overlay variation occurs. Also, the capacitance of the compensation capacitor Cm can be greater than the parasitic capacitance between the second gate line GL2 and the cushion pattern 142b. Therefore, even if there is a difference in parasitic capacitance between the first and second pixels P1 and P2 due to the overlay variation, the influence due to the variability in the parasitic capacitance can be reduced by the compensation capacitor Cm.

Meanwhile, the luminance deviation of the first and second pixels P1 and P2 due to the overlay variation can occur due to the capacitance deviation of the storage capacitor Cst as well as the parasitic capacitance deviation between the first gate line GL1 which is the own gate line and the second capacitor electrode 144. Thus, luminance deviation can increase as the overlay variation increases.

However, in the present disclosure, a portion of both ends of the second capacitor electrode 144 can be configured to protrude in the second direction Y without overlapping the first capacitor electrode 142, and the second capacitor electrode 144 excluding the protruding portion can be configured to be disposed over the first capacitor electrode 14, thereby minimizing the capacitance deviation of the storage capacitor Cst due to the overlay variation. By adjusting the area of the protruding portion, the influence of the parasitic capacitance between the first gate line GL1 and the second capacitor electrode 144 due to the overlay variation can be minimized. For example, in the electroluminescent display device according to the example of the present disclosure, when the second metal layer is shifted by 3µm in the positive or negative second direction Y with respect to the first metal layer and the overlay variation occurs, the parasitic capacitance deviation in the first and second pixels P1 and P2 due to the variation of the nth gate line GL(n) can be about 7.09%, and the parasitic capacitance deviation in the first and second pixels P1 and P2 due to the variation of the (n+1)th gate line GL(n+1) can be about 33.7%.

On the other hand, in the electroluminescent display device according to another example of the present disclosure, when the second metal layer is shifted by 3µm in the positive or negative second direction Y with respect to the first metal layer and the overlay variation occurs, the parasitic capacitance deviation in the first and second pixels P1 and P2 due to the variation of the nth gate line GL(n) can be about 7.08%, and the parasitic capacitance deviation in the first and second pixels P1 and P2 due to the variation of the (n+1)th gate line GL(n+1) can be about 25.7%, so the parasitic capacitance deviation can be reduced compared to the above example. As such, in the electroluminescent display device according to another example of the present disclosure, the cushion pattern 142b and the auxiliary power line AP can be configured to overlap each other, thereby forming the compensation capacitor Cm. Thus, even if there is a difference in parasitic capacitance between the first and second pixels P1 and P2 due to the overlay variation, the influence due to the variability in parasitic capacitance can be reduced by the compensation capacitor Cm thereby minimizing or eliminating the luminance deviation between the first and second pixels P1 and P2.

While FIGS. 7-9 depict examples where a width of the cushion pattern 142b is greater than a width of the auxiliary power line AP, in yet other examples, the width of the auxiliary power line AP (at least where the auxiliary power line AP overlaps the cushion pattern 142b) can be greater than a width of the cushion pattern 142b. Accordingly, the compensation capacitor Cm can once again have substantially the same capacitance in the first and second pixels P1 and P2 even if the above-described overlay variation occurs. Thus, even if there is a difference in parasitic capacitance between the first and second pixels P1 and P2 due to the overlay variation, the influence due to the variability in parasitic capacitance can be reduced by the compensation capacitor Cm.

Additionally, in the electroluminescent display device according to another example of the present disclosure, compared to the above example, since the distance between the second gate line GL2 and the storage capacitor Cst can be reduced, the area of the circuit part A can be minimized, and the area of the emission part EA can be increased. Accordingly, the aperture ratio can be increased, thereby preventing or minimizing the afterimage and increasing the lifetime of the light-emitting diode De. Further, the thin film transistor TR can be the driving transistor, the switching transistor, and/or the sensing transistor.

Further, in the electroluminescent display device of the present disclosure, by connecting and driving two adjacent sub-pixels to one output terminal of the data driving unit, the size and number of the data driving units can be preventing from increasing, thereby reducing the manufacturing costs. In addition, by providing the cushion pattern between the gate line and the storage capacitor adjacent to each other, the influence due to the adjacent gate line can be minimized, and the decrease in luminance can be prevented.

Moreover, by overlapping the cushion pattern and the power line to form the compensation capacitor, the influence due to the parasitic capacitance variation can be reduced by the compensation capacitor even if there is the difference in parasitic capacitance between two different sub-pixels due to the overlay variation, and thus the luminance deviation between the two sub-pixels can be minimized. Further, since the aperture ratio can be increased by minimizing the area of the circuit part, the afterimage can be prevented or minimized, and the lifetime of the light-emitting diode can be increased.

Further examples are set out in the clauses below:
1. An electroluminescent display device comprising:
   a substrate;
   a thin film transistor over the substrate;
   a storage capacitor electrically connected to the thin film transistor, the storage capacitor includes a first capacitor electrode and a second capacitor electrode overlapping the first capacitor electrode;
   a light-emitting diode electrically connected to the thin film transistor and the storage capacitor;
   a first gate line electrically connected to the thin film transistor and extending in a first direction;
   a second gate line spaced apart from the first gate line in a second direction crossing the first direction, the thin film transistor interposed between the first and second gate lines;
   an auxiliary power line between the first and second gate lines and electrically connected to the thin film transistor; and
   a cushion pattern between the second gate line and the storage capacitor,
   wherein the cushion pattern is electrically connected to the first capacitor electrode of the storage capacitor, and
   wherein the cushion pattern and the auxiliary power line overlap to form a compensation capacitor configured to compensate for variation in parasitic capacitance between the second gate line and the cushion pattern caused by overlay misalignment between a first conductive layer including the cushion pattern and a second conductive layer including the auxiliary power line.
2. The electroluminescent display device of clause 1, wherein the cushion pattern overlaps the auxiliary power line.
3. The electroluminescent display device of clause 2, wherein a width of the cushion pattern is equal to or greater than a width of the auxiliary power line in the second direction.
4. The electroluminescent display device of any one of the preceding clauses, wherein the cushion pattern is integrally formed with the first capacitor electrode of the storage capacitor.
5. The electroluminescent display device of any one of the preceding clauses,
   wherein the cushion pattern is electrically connected to both the first capacitor electrode and the light-emitting diode.
6. The electroluminescent display device of any one of the preceding clauses, wherein the first capacitor electrode overlaps the thin film transistor.
7. The electroluminescent display device of any one of the preceding clauses, wherein the thin film transistor includes a gate electrode, an active layer, a source electrode, and a drain electrode, and
   wherein the first capacitor electrode overlaps the gate electrode and the active layer.
8. The electroluminescent display device of clause 7, wherein the gate electrode overlaps and contacts the second capacitor electrode.
9. The electroluminescent display device of any one of the preceding clauses, wherein the first gate line is disposed between the light-emitting diode and the second gate line, and
   wherein the thin film transistor and the storage capacitor are disposed between the first gate line and the second gate line.
10. The electroluminescent display device of clause 1, wherein first and second pixels are provided over the substrate, and each of the first and second pixels includes a first sub-pixel, wherein each first sub-pixel of the first and second pixels includes an emission part and a circuit part, and
   wherein the circuit part of the first sub-pixel of the first pixel is symmetrical to the circuit part of the first sub-pixel of the second pixel in the second direction.
11. The electroluminescent display device of clause 10, wherein the circuit part of the first sub-pixel of the first pixel or the circuit part of the first sub-pixel of the second pixel is disposed between the first gate line and the second gate line, and the light-emitting diode is disposed in the emission part.
12. The electroluminescent display device of clause 10, wherein the first sub-pixel of the first pixel and the first sub-pixel of the second pixel emit light of same color.
13. The electroluminescent display device of any one of the preceding clauses, wherein first and second pixels are provided over the substrate, and each of the first and second pixels includes a first sub-pixel and a second sub-pixel,
   wherein each of the first and second sub-pixels of the first and second pixels includes an emission part and a circuit part, and
   wherein the circuit part of the first sub-pixel of the first and second pixels is symmetrical to the circuit part of the second sub-pixel of the first and second pixels in the first direction.
14. The electroluminescent display device of clause 13, wherein the first sub-pixel of the first and second pixels and the second sub-pixel of the first and second pixels emit light of different colors.
15. The electroluminescent display device of any one of the preceding clauses, further comprising a main power line and a data line extending in the second direction and crossing the first and second gate lines,
   wherein the auxiliary power line is connected to the main power line.
16. The electroluminescent display device of any one of the preceding clauses, wherein the thin film transistor is a driving transistor, a switching transistor, or a sensing transistor.
17. An electroluminescent display device comprising:
   a substrate;
   first and second pixels arranged adjacent to each other over the substrate in a first direction, each of the first and second pixels including at least one sub-pixel having a circuit part and an emission part;
   a thin film transistor disposed in the circuit part over the substrate;
   a storage capacitor electrically connected to the thin film transistor, the storage capacitor including a first capacitor electrode and a second capacitor electrode disposed over the first capacitor electrode;
   a light-emitting diode disposed in the emission part and electrically connected to the thin film transistor and the storage capacitor;
   a first gate line electrically connected to the thin film transistor and extending in the first direction;
   a second gate line spaced apart from the first gate line in a second direction crossing the first direction, the thin film transistor being interposed between the first and second gate lines;
   an auxiliary power line disposed between the first and second gate lines and electrically connected to the thin film transistor; and
   a cushion pattern disposed between the second gate line and the storage capacitor in the second direction,
   wherein the cushion pattern is electrically connected to the first capacitor electrode of the storage capacitor and overlaps the auxiliary power line to form a compensation capacitor therebetween, the compensation capacitor being configured to compensate for variation in parasitic capacitance between the second gate line and the cushion pattern caused by overlay misalignment between a first metal layer including the cushion pattern and a second metal layer including the auxiliary power line.
18. The electroluminescent display device of clause 17, wherein a width of the cushion pattern is different than a width of the auxiliary power line in the second direction.
19. The electroluminescent display device of clause 17 or 18, the cushion pattern is integrally formed with first capacitor electrode.
20. The electroluminescent display device of any one of clauses 17-19, wherein the circuit part of the sub-pixel of the first pixel is symmetrical to the circuit part of the sub-pixel of the second pixel in a second direction crossing the first direction.

It will be apparent to those skilled in the art various modifications and variations can be made in the display device of the present disclosure without departing from the technical idea or scope of the disclosure. Thus, it is intended the present disclosure covers the modifications and variations of this disclosure provided they come within the scope of the appended claims and their equivalents.

## Claims

1. An electroluminescent display device comprising:
a substrate;
a thin film transistor over the substrate;
a storage capacitor electrically connected to the thin film transistor, the storage capacitor includes a first capacitor electrode and a second capacitor electrode overlapping the first capacitor electrode;
a light-emitting diode electrically connected to the thin film transistor and the storage capacitor;
a first gate line electrically connected to the thin film transistor and extending in a first direction;
a second gate line spaced apart from the first gate line in a second direction crossing the first direction, the thin film transistor interposed between the first and second gate lines;
an auxiliary power line between the first and second gate lines and electrically connected to the thin film transistor; and
a cushion pattern between the second gate line and the storage capacitor,
wherein the cushion pattern is electrically connected to the first capacitor electrode of the storage capacitor, and
wherein the cushion pattern and the auxiliary power line overlap to form a compensation capacitor configured to compensate for variation in parasitic capacitance between the second gate line and the cushion pattern caused by overlay misalignment between a first conductive layer including the cushion pattern and a second conductive layer including the auxiliary power line.

2. The electroluminescent display device of claim 1, wherein the cushion pattern overlaps the auxiliary power line.

3. The electroluminescent display device of claim 2, wherein a width of the cushion pattern is equal to or greater than a width of the auxiliary power line in the second direction.

4. The electroluminescent display device of any one of the preceding claims, wherein the cushion pattern is integrally formed with the first capacitor electrode of the storage capacitor.

5. The electroluminescent display device of any one of the preceding claims,
wherein the cushion pattern is electrically connected to both the first capacitor electrode and the light-emitting diode.

6. The electroluminescent display device of any one of the preceding claims, wherein the first capacitor electrode overlaps the thin film transistor.

7. The electroluminescent display device of any one of the preceding claims, wherein the thin film transistor includes a gate electrode, an active layer, a source electrode, and a drain electrode, and
wherein the first capacitor electrode overlaps the gate electrode and the active layer.

8. The electroluminescent display device of claim 7, wherein the gate electrode overlaps and contacts the second capacitor electrode.

9. The electroluminescent display device of any one of the preceding claims, wherein the first gate line is disposed between the light-emitting diode and the second gate line, and
wherein the thin film transistor and the storage capacitor are disposed between the first gate line and the second gate line.

10. The electroluminescent display device of any one of the preceding claims, wherein first and second pixels are provided over the substrate, and each of the first and second pixels includes a first sub-pixel,
wherein each first sub-pixel of the first and second pixels includes an emission part and a circuit part, and
wherein the circuit part of the first sub-pixel of the first pixel is symmetrical to the circuit part of the first sub-pixel of the second pixel in the second direction.

11. The electroluminescent display device of claim 10, wherein the circuit part of the first sub-pixel of the first pixel or the circuit part of the first sub-pixel of the second pixel is disposed between the first gate line and the second gate line, and the light-emitting diode is disposed in the emission part; or optionally
the first sub-pixel of the first pixel and the first sub-pixel of the second pixel emit light of same color.

12. The electroluminescent display device of any one of the preceding claims, wherein first and second pixels are provided over the substrate, and each of the first and second pixels includes a first sub-pixel and a second sub-pixel,
wherein each of the first and second sub-pixels of the first and second pixels includes an emission part and a circuit part, and
wherein the circuit part of the first sub-pixel of the first and second pixels is symmetrical to the circuit part of the second sub-pixel of the first and second pixels in the first direction; and optionally
wherein the first sub-pixel of the first and second pixels and the second sub-pixel of the first and second pixels emit light of different colors.

13. The electroluminescent display device of any one of the preceding claims, further comprising a main power line and a data line extending in the second direction and crossing the first and second gate lines,
wherein the auxiliary power line is connected to the main power line; or optionally
wherein the thin film transistor is a driving transistor, a switching transistor, or a sensing transistor.

14. The electroluminescent display device of claim 1 further comprising
first and second pixels arranged adjacent to each other over the substrate in a first direction, each of the first and second pixels including at least one sub-pixel having a circuit part and an emission part;
wherein the thin film transistor is disposed in the circuit part over the substrate;
the light-emitting diode is disposed in the emission;
the cushion pattern disposed between the second gate line and the storage capacitor in the second direction, and
wherein the cushion pattern overlaps the auxiliary power line to form a compensation capacitor therebetween, and wherein the first conductive layer and second conducive layer comprise a first metal layer and a second metal layer.

15. The electroluminescent display device of claim 14, wherein a width of the cushion pattern is different than a width of the auxiliary power line in the second direction; or optionally wherein
the cushion pattern is integrally formed with first capacitor electrode; or optionally
wherein the circuit part of the sub-pixel of the first pixel is symmetrical to the circuit part of the sub-pixel of the second pixel in a second direction crossing the first direction.
